(19) **Europäisches Patentamt / European Patent Office / Office européen des brevets**

(11) **EP 4 581 349 B1**

(12) **EUROPEAN PATENT SPECIFICATION**

(45) Date of publication and mention
of the grant of the patent:
**29.07.2026  Bulletin 2026/31**

(21) Application number: **23727481.6**

(22) Date of filing: **12.05.2023**

(51) International Patent Classification (IPC):
**G01N 21/27** (2006.01)  **G01N 21/35** (2014.01)
**G01N 21/65** (2006.01)  **G06N 3/126** (2023.01)
**G01R 33/46** (2006.01)  **G01N 21/359** (2014.01)

(52) Cooperative Patent Classification (CPC):
**G01N 21/35; G01N 21/274; G01N 21/65;
G06N 3/126;** G01N 21/359; G01N 2201/129;
G01R 33/46

(86) International application number:
**PCT/EP2023/062698**

(87) International publication number:
**WO 2024/046603 (07.03.2024 Gazette 2024/10)**

(54) **METHOD, COMPUTER PROGRAM PRODUCT AND DEVICE FOR PROVIDING A PREDICTIVE MODEL FOR SPECTROSCOPY AND METHOD FOR CALIBRATING A SPECTROSCOPIC DEVICE**

VERFAHREN, COMPUTERPROGRAMM UND VORRICHTUNG ZUR BEREITSTELLUNG EINES VORHERSAGEMODELLS FÜR DIE SPEKTROSKOPIE UND VERFAHREN ZUR KALIBRIERUNG EINER SPEKTROSKOPISCHEN VORRICHTUNG

PROCÉDÉ, PROGRAMME INFORMATIQUE ET DISPOSITIF POUR FOURNIR UN MODÈLE PRÉDICTIF POUR LA SPECTROSCOPIE ET PROCÉDÉ POUR ÉTALONNER UN DISPOSITIF SPECTROSCOPIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **29.08.2022  EP 22192601**

(43) Date of publication of application:
**09.07.2025  Bulletin 2025/28**

(73) Proprietor: **Büchi Labortechnik AG
9230 Flawil (CH)**

(72) Inventors:
• **RAMIREZ-LOPEZ, Leonardo**
  **9000 St. Gallen (CH)**
• **ORELLANO, Claudio**
  **8400 Winterthur (CH)**
• **PEREZ-FERNANDEZ, Estefania**
  **9000 St. Gallen (CH)**
• **DIAZ, Michelle**
  **8032 Zürich (CH)**
• **KONATSCHNIG, Sandro**
  **9225 St. Pelagiberg (CH)**

(74) Representative: **Laminger, Norbert
ABP Patent Network AG
Othmarstrasse 8
8008 Zürich (CH)**

(56) References cited:
  CN-B- 106 979 934    CN-B- 109 283 153
  US-A1- 2013 080 070    US-A1- 2022 128 474

• **ADITYA TULSYAN ET AL: "A machine-learning approach to calibrate generic Raman models for real-time monitoring of cell culture processes", BIOTECHNOLOGY AND BIOENGINEERING, JOHN WILEY, HOBOKEN, USA, vol. 116, no. 10, 21 July 2019 (2019-07-21), pages 2575 - 2586, XP071153613, ISSN: 0006-3592, DOI: 10.1002/ BIT.27100**

**Description**

BACKGROUND OF THE INVENTION

The present invention refers to calibration of spectroscopic devices for the quantification of properties of materials.

Spectroscopy refers to the interaction between matter and radiated energy at different frequencies. Spectroscopy deals with the quantitative measurement of absorption, reflection, transmission, or emission of energy by a material that is subjected to electromagnetic radiation. The concentration of the components and the physical characteristics (hereinafter jointly referred to as "response variables") of a material influence the way in which that material absorbs, reflects, transmits, or emits electromagnetic radiation. In this respect, it is possible to quantify the response variables of a material from a measurement of its absorption, reflection, transmission, or emission variables (hereinafter referred to as "spectral variables").

The measurement of these spectral variables from a given sample is carried out with spectrometers, which are devices that record such returned energy at multiple energy frequencies or periods (e.g. wavenumbers or wavelengths) resulting in a spectrum or signal of the measured sample. The quantification of the response variables is usually done through empirical predictive models which are calibrated using statistical regression methods (e.g. partial least squares regression).

One response variable requires the calibration of a single predictive model. Such predictive model can be described by the following equation:

$$y = f(x) + \varepsilon,$$

where:

- $x$ represents a spectrum, for example an infrared spectrum which can refer to the actual measurement of a device,
- $y$ represents a response value (for example protein content of a sample)
- $f$ represents the predictive model or mathematical function, which is obtained by using a regression method and calibrated to predict y from x, and
- $\varepsilon$ represents an error value of the prediction.

Analytical techniques based on spectroscopy (such as visible, near-infrared, mid-infrared, and Raman spectroscopy) are widely used in the quantification of response variables of materials and end products involved in the production of agricultural, food, feed, and pharmaceutical goods. For example, fat content in a given cheese sample can be quantified by using a predictive model that uses its spectral variables as predictors. Since, in practice, a material or product requires the quantification of various response variables (e.g. fat content, protein content, moisture content, etc.) it is then necessary to have a predictive model for each response variable. The collection of predictive models used to quantify the different response variables required for the quantitative analysis of a given product or material is hereinafter referred to as an "spectroscopic application". For example, a cheese application may contain predictive models for the quantification of fat, protein, and moisture contents.

A spectroscopic application is used in a spectrometer system. A spectrometer system comprises a spectrometer device that is used to measure the spectral variables of materials or products; a data transmitter; a data processing unit that can be used to consume one or more spectroscopic applications to infer the quantitative results of response variables from the measurements of the spectral variables of the measured products or materials; and a data storage unit to store data of the response variables and spectral measurements of samples. Thus, the data processing unit and the data storage unit may, for example, be located inside the spectrometer device, located in the vicinity of the spectrometer device, or located remotely. The spectroscopic application may also be considered part of the spectrometer system. The spectrometer system can be considered as operational for a given spectroscopic application when it is able to deliver acceptable predictions of the response variables the spectroscopic application was built for.

To obtain the predictive models for a spectroscopic application a training dataset is required. A training dataset contains data of a number of samples (typically from hundreds to thousands) of a given product or material, in which each sample includes the value(s) for one or more response variables (measured by standard analytical methods) and the values of its spectral variables. The samples in the training set must be representative of the population of interest so that the predictive models calibrated from them can properly predict the unknown response values from the spectral measurements of samples to be measured in the future when the spectroscopic application is put to use.

The development of spectroscopic applications may be tedious, time consuming and expensive, especially because of the steps involved in building a training set that is representative of the target population or subpopulation. For example, long seasonal variations in the compositional or physical characteristics, or even seasonal availability of a target product or material, may considerably increase the time required to build an appropriate training set. In addition, the measurement of the required response variables (needed in the training set) by conventional laboratory methods is also often cumbersome and expensive. To circumvent the drawbacks inherent to building a new training set, pre-existing training sets can also be used to create a given spectroscopic application.

However, there are two problems associated to pre-existing training data. The first one is that availability of such training sets to end users of spectroscopic systems is usually very limited. The second problem is that predictive models built from pre-existing training datasets may include a considerable number of samples that are not related to the target population as these originate from other populations with different distributions of their measured compositional, physical, and spectroscopic characteristics. For example, a spectroscopic application built from a pre-existing training set that includes a wide variety of cheese types might tend to generalize poorly when applied on samples of a unique cheese type or recipe. Another example where spectroscopic applications are prone to fail is when the instruments or methods employed to measure the target population deviate from those employed on the samples of the pre-existing training dataset of that spectroscopic application. In some cases, augmenting the pre-existing training set with few training samples from the target population might attenuate the poor generalization problem of the spectroscopic applications aimed at the target population.

To avoid all the drawbacks that imply building a spectroscopic application, end users often choose to obtain their spectroscopic applications from the spectrometer supplier or from a third party, which could be seen as a service provider for the user. Still, these providers usually require investing efforts towards adjusting their spectroscopic applications to guarantee acceptable predictive accuracy of the response variables in the target population and therefore in such cases end users will have to wait for these adjustments to be successfully completed until their spectroscopic application can be considered operational.

Several methods aiming at mitigating the complexity of building spectroscopic applications have been proposed.

For example, in DE 10 2016 124 867 A1, a method for building training sets to calibrate spectroscopic applications for "inline" spectrometers is disclosed. In that method, apart from the spectrometer, an additional device is used to measure a response variable. Both, the measurements of the response variable and the measurement of the spectral variables are carried out simultaneously. Although this method simplifies data acquisition for building a new training set, it does not guarantee efficiency in terms of time required to collect a representative set of samples and it can also be expensive since an additional measurement device is required.

The methods disclosed in US 2020/0043574 A1, US 2001/0037182 A1 and CN 108169132 A describe systems where users send spectra to a remote system where pre-existing spectroscopic applications are used to predict the response variables of interest, then, these predictions are sent to the user or to the spectrometer system to present the final results to the user. In these methods, spectroscopic applications are centralized and may not necessarily be directly available to end users and therefore, in such cases, constraining the updates of the spectroscopic application.

The method disclosed in WO 2006/126950 A1 describes a system for distributing or deploying pre-existing predictive models for spectroscopic applications in different spectrometers connected to such system. The method encrypts the data in the spectroscopic applications to be deployed which also constrains the data accessibility and updates of such applications by the end users.

In the previous four methods (US 2020/0043574 A1, US 2001/0037182 A1, CN 108169132 A, and WO 2006/126950 A1) the exchange of data may take place through the Internet (e.g. cloud computing) and/or other telecommunication links. Despite these methods are efficient for exchanging data, they do not consider on demand adjustment of the spectroscopic applications to the target population.

US2022/128474 A1 relates generally to the monitoring and/or control of biopharmaceutical processes using spectroscopic techniques, such as Raman spectroscopy, and more specifically relates to the online calibration and maintenance of prediction models.

In particular, according to US2022/128474 A1 a local predictive model is calibrated using training data, the training data being selected by:

- determining, by one or more processors, a query point associated with scanning of the biopharmaceutical process by a spectroscopy system; and
- querying, by the one or more processors, an observation database containing a plurality of observation data sets associated with past observations of biopharmaceutical processes, wherein each of the observation data sets includes spectral data and a corresponding actual analytical measurement, and wherein querying the observation database includes selecting as training data, from among the plurality of observation data sets, observation data sets that satisfy one or more relevancy criteria with respect to the query point;
- wherein determining a query point includes determining the query point based at least in part on a spectral scan vector, the spectral scan vector being generated by the spectroscopy system when scanning the biopharmaceutical process.

US 2013/080070 A1 describes identifying and selecting a more accurate chemometric model for the analysis of specific plant samples via near infrared spectrometry.

CN 106979934 A describes drug storage data processing by correlation coefficients, in particular to a method for drug near-infrared spectrum data integration, library building and application to unknown drug physicochemical index quick determination.

CN109283153A describes constructing a quantitative analysis model, where the type of the to-be-tested sample can be judged through the spectral characteristics of the sample to be detected, and a high-specificity quantitative analysis model is constructed in real time.

"A machine-learning approach to calibrate generic Raman models for real-time monitoring of cell culture processes" in Biotechnology and bioengineering vol. 116,10 (2019): 2575-2586 by Aditya Tulsyan, et al. describes a machine-learning procedure based on just-in-time learning (JITL) to calibrate Raman models.

Thus, known from prior art is that to obtain an operational spectroscopic application may choose from any of the following options: *i.* develop it from a new training dataset with representative samples drawn from their product population; *ii.* develop it from a pre-existing training set which may, or may not, be augmented with few samples drawn from their product population; *iii.* obtain it from a third-party supplier; or alternatively *iii.* outsource the necessary predictions of the response variable which store the spectroscopic applications in a remote data processor (e.g. the cloud).

Disadvantages in the prior art are that spectroscopic applications can be expensive to be developed; or cannot guarantee an optimal adjustment to perform predictions of the response variable(s) in the target population; or difficult to access and update.

SUMMARY OF THE INVENTION

The object of the present invention is thus to overcome the disadvantages of the prior art and to provide an improved method and system for on-demand generation of spectroscopic applications that are automatically adjusted to the target product or material population based on few samples drawn from that population which not necessarily contain data of the response variable(s). A spectroscopic application generated using the proposed method can be deployed into a specific spectrometer system and can also be later updated on-demand. Thereby the present invention aims at solving all the previously listed disadvantages of the prior art, or at least to provide an alternative to existing solutions.

The present invention solves this object by providing a method, apparatus, and system according to the independent claims.

It is intended that the present invention is effectively applicable to other types of analytical instruments that use predictive models to quantify response variables in a material or product.

The present invention solves this object by the subject-matter laid out in the independent claims, wherein further advancements are detailed in the respective dependent claims.

One aspect of the present invention refers to a computer-implemented method for providing a predictive model for spectroscopy of a target population of a product or material, wherein the predictive model predicts a response value indicating a physical and/or chemical property of the product or material from one or more spectral values indicating physical properties of the product or material. In the method one or more spectral measurements of samples of the target population are obtained, wherein each spectral measurement comprises one or more sample spectral values.

Then a database search is performed using the sample spectral values as input data and having as output data a database result that maximizes the accuracy of the predictive model for spectroscopy of other samples of the target population, when the predictive model is determined from the result.

The database search is performed in two types of databases.

The first type is a database comprising a plurality of stored spectral measurements and a plurality of corresponding stored response measurements, wherein the result of the database search comprises stored spectral measurements and corresponding stored response measurements.

The second type is a database comprising a plurality of stored predictive models, wherein the result of the database search comprises one or more stored predictive models.

As said, the database search is performed in the two types of databases or in two or more databases of every type, for example one database of the first type and two databases of the second type.

The method then proceeds with determining the predictive model based on at least the result of the database search.

By executing the above method, on-demand generation of spectroscopic applications that are automatically adjusted to the target product or material population based on few samples drawn from that population which not necessarily contain data of the response variable(s) is improved.

According to one embodiment the predictive model can also, i.e. additionally, be determined on the basis of the obtained spectral measurements of samples of the target population.

Thereby the quality of the predictive model can be further improved.

According to another embodiment, the step of obtaining can further comprise

obtaining one or more response measurements of the samples of the target population, wherein each response measurement comprises one response value, and wherein the predictive model is also, i.e. additionally, determined on the basis of the obtained response values.

Thereby, also, the quality of the predictive model can be further improved.

According to another embodiment, the spectral and response measurements can refer to one type of near-infrared spectroscopy, mid-infrared spectroscopy, Raman spectroscopy, Nuclear Magnetic Resonance spectroscopy or any other similar optical or emission-based spectroscopy, and wherein the model is provided for the same type of spectroscopy.

The presented solutions are applicable to any of the above technologies, and possibly others as well.

According to another embodiment the database search can be performed using an optimization method, preferably based on evolutionary search algorithms and/or sample similarity measurements.

This also contributes to improving the result and thereby improves the quality of the predictive model.

According to another embodiment the step of determining the predictive models is performed by means of machine learning and/or chemometrics methods.

By employing machine learning and/or chemometrics methods, the determination of the predictive model is improved.

According to another embodiment, the predictive model can be packed into a spectroscopic application having a proprietary data format.

By implementing the model into an application, also described as packing the model into the application, further advantages are achieved, namely, an application that can be supplied to a customer is provided.

According to another embodiment, the method can be part of a method for calibrating a spectroscopic device configured for spectroscopy of a target population of a product or material in that before the method, as described above, one or more spectral measurements of samples of the target population are acquired by the spectroscopic device. The acquired spectral measurements are uploaded to a data processing server which then performs the method as laid out above, thereby generating the predictive model for spectroscopy. The generated predictive model is then downloaded from that server and installed into the spectroscopic device, thereby calibrating the spectroscopic device to be operational for the target population of the product or material.

This embodiment is advantageous, since the device is calibrated with a minimum effort on the side of the user of the device.

According to another embodiment, the step of acquiring can further comprise acquiring, by the spectroscopic device, one or more response measurements of the samples of the target population, and the step of uploading can further comprise uploading the acquired response measurements.

Thereby, the quality of the predictive model can be further improved.

According to another embodiment, the spectroscopic device can be one of a near-infrared spectroscopy device, a mid-infrared spectroscopy device, a Raman spectroscopy device, a Nuclear Magnetic Resonance spectroscopy device or any other similar optical or emission-based spectroscopy device.

The presented solutions are applicable to any of the above technologies, and possibly others as well.

According to another embodiment, the method can, after installing, further comprise

acquiring, by the spectroscopy device, one or more additional spectral and/or response measurements of new target samples of the target population and updating the installed predictive model based on the measurements of the new target samples.

Thereby, the installed predictive model can be adapted easily, by the provision of further measurements.

Other aspects of the invention refer to computer program products and devices.

It is noted that the subject-matter of the embodiments described for the method can also be employed in the other aspects, wherein even embodiments can be combined.

BRIEF DESCRIPTION OF THE DRAWINGS

The embodiments are illustrated in the drawings in which like reference numerals refer to like elements and in which:

Fig. 1      shows a schematic representation of an on-demand calibration system for spectroscopic devices according to the present invention; and

Fig. 2      shows flow charts illustrating the methods according to the present invention.

It is noted that in the differently described embodiments, the same parts are provided with the same reference numbers or the same component designations, wherein the disclosure can be applied to the same or similar parts with the same or similar reference numbers or the same or similar component designations. The position designations in the description, such as top, bottom, side, etc., are related to the directly described and illustrated figure and these position designations can be transferred to other positions for other figures.

DETAILED DESCRIPTION OF THE INVENTION

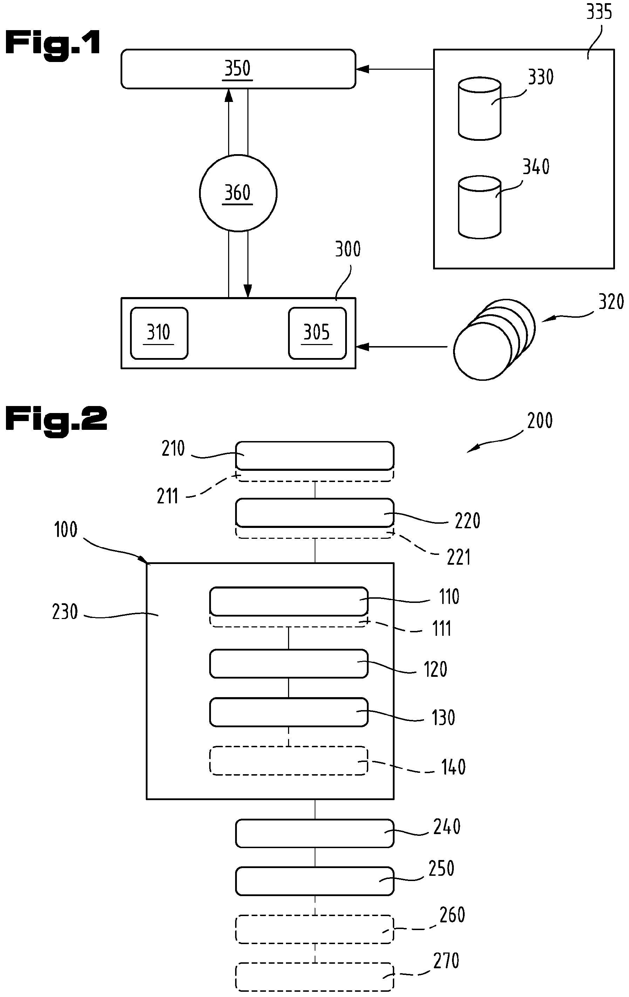

Fig. 1 shows a schematic representation of an on-demand calibration system for spectroscopic devices according to the present invention. Therein optional features are included, which will become apparent from the description. It is also noted that Fig. 1 only shows one possible arrangement of components, and different composition of system parts and entities is possible as well. Further the number of each component is chosen to facilitate the description of the system, but several identical items can possible be present. Fig. 2 shows flow charts illustrating the methods according to the present invention, therein optional steps are indicated by dashed lines.

Since the subject-matter of both figures is interleaving, the invention will be described in the following using all figures at the same time.

Method 100 for providing a predictive model as depicted in Fig. 2 generates a predictive model for spectroscopy of a target population of a product or material. Such a predictive model, in the context of this disclosure, predicts a response value from one or more spectral values. The response value as well as the spectral values refer to the product or material. Further, the spectral values, a spectral value is sometimes also called spectrum, indicate physical properties of the product or material, wherein the response value indicates a physical and/or chemical property of the product or material.

Method 100 can for example be performed in a data processing server 350, but generally any computing device configured to perform the inventive method can generate the predictive model.

Method 100 starts with obtaining 110 one or more spectral measurements of samples 320 of the target population, wherein each spectral measurement comprises one or more sample spectral values.

The spectral measurements can be obtained from the data processing server 350 by means of a data transmitter 360, as shown in Fig. 1, but also in various other ways. For example, on a data carrier, like a USB stick, a CD-ROM or DVD, from a database, etc.

For the generation of the predictive model, the source or origin of the spectral measurements is not important. Preferably, the spectral measurements have been taken, i.e. measured, with the spectroscopy device 310 where the predictive model is to be used later-on, or at least on a similar model of spectroscopy devices, but in general this is not required.

The data of the samples drawn from the target population (hereinafter referred to as target samples) comprises the spectral variables, i.e., the spectral values.

The data processing server 350 can optionally also obtain, in step 111, one or more response measurements of the samples 320 of the target population. Each response measurement comprises one response value.

The data processing server 350 then performs in step 120 a database search in databases 330, 340 using the sample spectral values from the obtained spectral measurements as input data.

The databases that are searched are of two types.

The first type of database 330 is a database 330 comprising a plurality of stored spectral measurements and a plurality of corresponding stored response measurements.

The second type of database 340 is a database 340 comprising a plurality of stored predictive models.

The databases 330, 340 can be an integral part of the data processing server 350 or on a peripheral device. They can also, for example, as shown in Fig. 1 be part of a data storage server 335, which in turn is in communication with the data processing server.

It is noted that the database search is performed in two or more databases 330, 340 of the two types of databases 330, 340, for example in three databases 330 of the first type and one database 340 of the second type.

The database search searches for database elements that maximize the accuracy of the predictive model for spectroscopy of other samples 320 of the target population, when the predictive model is determined from the result.

The output of databases 330 of the first type comprises stored spectral measurements and corresponding stored response measurements, whereas the output of databases 340 of the second type comprises one or more stored predictive models.

The measurements of the target samples 320 transmitted by the system or by the user to the data processing server 350 are used to find in a pre-existing training database 330, stored for example in a remote data storage server 335, the optimal subset of training samples that can better represent the target population. To find this optimal subset of training samples, the data processing server 350 can employ a metric to assess the training subset suitability. If an optimal subset of training samples is found, it can then be used by the data processing server 350 to develop a predictive model for each response variable that is to be included in the spectroscopic application. In case the data processing server 350 does not find an optimal training subset to build predictive models for one or more response variables required in the spectroscopic application, the user will be notified, and the spectroscopic application will be built only for those response variables for which the training subset is suitable, if any.

In addition to the database 330 of training samples, for each response variable a database 340 of predictive models can also be available, again for example at the remote data storage server 335. In this respect, the target samples 320 can be used to find in the database 340 of predictive models an optimal subset of predictive models. If more than one predictive model is found to be optimal for predicting a given response variable, then, the predictive models found can be used in an ensemble fashion, and the resulting ensembles be included in the spectroscopic application. To find this optimal subset of predictive models, the data processing server 350 employs a metric to assess the suitability of the predictive models in the database 340, in either an ensemble fashion or not. In case the data processing server 350 does not find an optimal subset of predictive models for one or more response variables required in the spectroscopic application, the user will be notified, and the spectroscopic application will be built only for those response variables for which the predictive models found are suitable, if any.

To exemplify how to evaluate if a subset of training samples found in the training database 330 can be considered as optimal, the following alternatives are given: i. its samples are the closest or less dissimilar to the target samples in terms of their spectral variables and or in terms of their response variables if the values of the response variable(s) are available for the target samples; ii. its samples can be used to build a spectral projection model (e.g. through principal component analysis or projection to latent structures) that can be used to optimally project the spectra of the target samples into new few variables without considerable loses of information carried by the original spectral variables; iii. its samples minimize the prediction error of the response variable(s) in the target samples, in case values of the response variable(s) are available for these samples; and iv. its samples are considered optimal from a combined perspective of at least two of the previous points.

To exemplify how to evaluate if a subset of predictive models found in the database of predictive models 340 can be considered as optimal, the following alternatives are given; i. if the models are based on projection methods (e.g. principal component analysis or projection to latent structures) each of these can be used to optimally project the spectra of the target samples into new few variables without considerable loses of information carried by the original spectral variables; ii. its predictive models minimize the prediction error of the response variable(s) in the target samples, in case the values of the response variable(s) are available for these samples; and iv. its samples are considered optimal from a combined perspective of the two previous points.

As an example, the database search 120 can be performed using an optimization method, preferably based on evolutionary search algorithms and/or sample similarity measurements.

Optimal training samples and/or optimal predictive models are found by the data processing server 350 by using optimization algorithms. Apart from the above examples on how to find the optimal training subsets and predictive models in the training database 330 and in the database of predictive models 340 respectively, other methods may also be employed. The usage of evolutionary algorithms to search for the optimal training samples and/or optimal predictive models have been found to be particularly efficient.

The method then proceeds to step 130, which is determining the predictive model based on at least the result of the database search.

As an option, the obtained spectral measurements, or the spectral values to be more precise, can also be used in the determination 130 of the predictive model. The predictive model would then be determined 130 on the basis of the spectral values and the database search result.

If, in the optional step 111, response values were also obtained, the determination 130 can also, i.e. additionally, be based on these obtained response values.

While measured values of the response variable(s) in the target set are not mandatory, if provided, these can be used to support the development of the predictive models for the response variable(s) required in the model or spectroscopic application. In the case where the training database 330 is used, and the values of the response variable(s) are provided in the target samples, these samples can then be used to augment the optimal training subset of samples found. This augmented training dataset can then be used by the data processing server 350 to build the predictive models of the requested spectroscopic application. In the case where the database of predictive models 340 is used and if the values of the response variable(s) are provided in the target samples, the data processing server 350 can use these target samples to create a predictive model for each response variable requested and this model can be used along with the optimal predictive subset of models found to produce an ensemble of predictive models.

Thereby, the additional benefit of a possible large amount of pre-existing training data 330 and predictive models 340 stored in the data storage server 335 may increase the likelihood of finding a subset of training samples and/or a subset of predictive models from which final predictive models with acceptable accuracy can be built.

The model can for example be determined 130 by means of machine learning and/or chemometrics methods. For example, by using regression analysis based on the partial least squares algorithm.

According to another embodiment, the method can further comprise packing 140 the predictive model into a spectroscopic application having a proprietary data format. Even more than one model could be packed into an application.

Thus, a spectroscopic application may contain predictive models built using the approach in which the training database 330 is used, and predictive models built using the approach in which the database of predictive models 340 is used.

The spectroscopic application could also be built 140 by using a different predictive model for each of the response variables.

Preparing 140 the spectroscopic application could further comprise determining 130 the predictive models required for each response variable in the spectroscopic application e.g. protein, fat, and moisture contents. These predictive models are specific to the target population and can be specific to one of the devices, the product or material, the product-type, or one or more properties of the product or the product-type.

The spectroscopic application containing the predictive model(s) may be a file in a proprietary data format, so that it can be installed into a spectrometer system 300.

In summary, and in other words, the data processing server 350 can generate 100 the predictive model, and a spectroscopic application, into which the predictive model can be packed 140 as explained below, based on the received target samples. Ideally the spectroscopic measurements of the target samples 320 are carried out with the same spectrometer device 310 of the spectrometer system 300 where the model or spectroscopic application is to be deployed, but it is also possible that a similar spectrometer is used for such measurements. This, in particular, can be the same spectrometer model or a different but compatible spectrometer model.

It could further be helpful if the user of the system provides information on the product or material type along with the response variables, that the model is meant to predict.

According to another embodiment, a method 200 for calibrating a spectroscopic device 310 configured for spectroscopy of a target population of a product or material is described. In this method the spectroscopic device 310, first acquires 210 one or more spectral measurements of samples 320 of the target population, wherein each spectral measurement comprises one or more sample spectral values.

The acquired spectral measurements are then uploaded 220 to a data processing server 350.

Following that, the data processing server 350 then generates 230 a predictive module for spectroscopy. It is noted that step 230 comprises the aforementioned method 100 of providing a predictive model, and in that combines the steps 110, 120 and 130, and optionally 111 and/or 140.

The predictive module is then downloaded from the data processing server 350 and installed 250 into the spectroscopic device 310, thereby calibrating the spectroscopic device 310 to be operational for the target population of the product or material.

Similar to the details above, the predictive model predicts a response value indicating a physical and/or chemical property of the product or material from one or more spectral values indicating physical properties of the product or material.

In other words, a spectroscopic application can be developed for a target population and for a spectrometer system 300, by obtaining 210 measurements of the spectral variables of one or more target samples 320 of a product or material taken with a spectrometer system 300, uploading 220, e.g. by a data transmitter 360, the obtained target sample measurements to a data processing server 350, generating 230, at this server 350, a spectroscopic application for the spectrometer system 300 as described herein, downloading 240, e.g. by the data transmitter 360, the generated spectroscopic application from the data processing server 350, and installing 250 the downloaded spectroscopic application into the spectrometer system 300, thereby making the spectrometer system 300 operational for that spectroscopic application.

Similar to the method 100 and apparatus described before, it is advantageous therein that the data processing server 350 can generate the spectroscopic application based on the received measurements of the spectral variables of the target samples 320. The server 350 uses these measurements provided and transmitted by the system or by user to generate 230 the spectroscopic application. Ideally the measurements are taken with the same spectrometer device 310 of the spectrometer system 300 where it is to be installed or deployed, but it is also possible that a similar spectrometer device is used for taking the measurements. This, in particular, can be the same spectrometer device model or a different but compatible spectrometer device model.

With reference to the optional step 111 of method 100, in which, in addition to the spectral values also in response values are obtained, in method 200 the step of acquiring 210 can further comprise acquiring 211, by the spectroscopic device 310, one or more response measurements of the samples 320 of the target population. The step of uploading 220, then can further comprise uploading 221 the acquired response measurements.

As a consequence, in the step 230, which basically includes the step 110, as laid out above, then the step 111 can also be included.

According to another embodiment, method 200 can further comprise, after installing 250, acquiring 260, by the spectroscopy device 310, one or more additional spectral and/or response measurements of new target samples 320 of the target population, and updating 270 the installed predictive model based on the measurements of the new target samples 320.

Thereby, the method 200 can update the installed spectroscopic applications generated by the method 200. For these updates, one or more additional target samples can be collected and measured. If the data of the new target samples contain response values, which have been, for example, measured by conventional laboratory methods, the predictive models in the spectroscopic application for which these response values are available can be directly updated by the processing unit of the spectrometer system. If response values are not available for the new target samples, the spectral variables of the new target samples together with all the selected previous target samples are transmitted to the data processing server where a new version of the spectroscopic application is built and sent back to the spectrometer system using the methods previously described in this invention.

Thereby, the calibration model of a device can be updated to reflect changes in the product or material over time or other changes in the environment in which spectral measurements take place.

That means, the method 200 can comprise taking one or more measurements of the target samples and/or retrieving data corresponding to previous measurements of target samples from a data storage 305 in order to obtain the one or more target sample measurements or the one or more additional target sample measurements.

It has been found to be beneficial that at least some of the target samples for the development of a new spectroscopic application and/or at least some of the target samples collected for the purpose of spectroscopic application updates can be retrieved from the data storage 305 unit in the spectrometer system.

Data storage 305 can also be used to store the predictive model(s) and the spectroscopic application(s).

It is noted that if the model is packed 140 into an application, as described above, all techniques using the predictive model, that are described herein, can also be applied to the application. This, in particular, refers to downloading 240 the predictive model, installing 250 the predictive model, and updating 270 the installed predictive model.

In another aspect, a system is described that can comprise a data storage server 335, configured to store the database of pre-existing training data 330 and the database of predictive models 340, a data processing server 350, configured to generate the spectroscopic application as described, a spectrometer system 300 comprising a spectrometer device 310 configured to obtain one or more sample measurements of a target product or material, a data transmitter 360, configured to upload the obtained sample measurements to a server and to download the generated spectroscopic calibration from the data processing server 350 and install it into the spectrometer system 300, thereby making the spectrometer system 300 operational.

Similar to the beneficial method and apparatus described before, it is advantageous therein that the data processing server 350 can generate the spectroscopic application based on the received target sample measurements. The data processing server 350 uses the measurements of the samples 320 provided and transmitted by the user to generate the spectroscopic application. Ideally the spectral variables of the target samples 320 are taken with the spectrometer device 310 in which the spectroscopic application is to be deployed or installed, but it is also possible that a similar spectrometer device 310 is used for taking such measurements. This, in particular, can be the same spectrometer device model or a different one but compatible spectrometer device model.

In general, all of the describes techniques can be applied to the following spectroscopy variants: near-infrared spectroscopy, mid-infrared spectroscopy, Raman spectroscopy, Nuclear Magnetic Resonance spectroscopy or any other similar optical or emission-based spectroscopy. The predictive model is then provided for the type of spectroscopy that the techniques are applied to. This refers not only to the method, but also to the devices as described herein.

It is further advantageous, if the spectrometer is designed to measure visible spectra, near-infrared spectra, mid-infrared spectra, Raman spectra or a combination of one or more of the previous types of spectra.

Moreover, the presented techniques are also applicable to other types of analytical instruments that use predictive models to quantify response variables in a material or product.

A further embodiment is a computer program product with a program for a data processing device, comprising software code sections for executing the steps of the method described above when the program is executed on the data processing device.

This computer program product can comprise a computer-readable medium on which the software code sections are stored, wherein the program can be loaded directly into an internal memory of the data processing device.

The exemplary embodiments show possible implementation variants, whereby it should be noted at this point that the invention is not limited to the specifically described design variants, but rather various combinations of the individual features with one another are possible. In particular, the features described in context of the method can also be included into the device.

The scope of protection is determined by the claims. However, the description and the drawings are to be used to interpret the claims.

Individual features or combinations of features from the different exemplary embodiments shown and described can represent independent inventive solutions. The object on which the independent inventive solutions are based can be found in the description.

All information on value ranges in the present description are to be understood in such a way that they include any and all sub-ranges thereof, e.g. the information 1 to 10 is to be understood in such a way that all sub-ranges, starting from the lower limit 1 and the upper limit 10, are also included, i.e. all sub-ranges begin with a lower limit of 1 or greater and end at an upper limit of 10 or less, for example 1 to 1.7, or 3.2 to 8.1, or 5.5 to 10.

## LIST OF REFERENCE SIGNS

| | |
|---|---|
| 100 | Method for providing a predictive model |
| 110 | Obtaining spectral measurements |
| 111 | Obtaining response measurements |
| 120 | Performing a database search |
| 130 | Determining predictive model |
| 140 | Packing the predictive model into a spectroscopic application |
| 200 | Method for calibrating |
| 210 | Acquiring spectral measurements |
| 211 | Acquiring response measurements |
| 220 | Uploading spectral measurements |
| 221 | Uploading response measurements |
| 230 | Generating the predictive model |
| 240 | Downloading the predictive model |
| 250 | Installing the predictive model |
| 260 | Acquiring additional measurements |
| 270 | Updating the predictive model |
| 300 | Spectroscopy system |
| 305 | Data storage |
| 310 | Spectroscopy device |
| 320 | Target samples |
| 330 | Database of first type |
| 335 | Data storage server |
| 340 | Database of second type |
| 350 | Data processing server |

360     Data transmitter

**Claims**

1. Computer-implemented method (100) for providing a predictive model for spectroscopy of a target population of a product or material, wherein the predictive model predicts a response value indicating a physical and/or chemical property of the product or material from one or more spectral values indicating physical properties of the product or material, comprising:

   obtaining (110) one or more spectral measurements of samples (320) of the target population, wherein each spectral measurement comprises one or more sample spectral values;
   performing (120) a database search using the sample spectral values as input data and having as output data a database result that maximizes the accuracy of the predictive model for spectroscopy of other samples (320) of the target population, when the predictive model is determined from the result;
   wherein the database search is performed

   in a database (330) comprising a plurality of stored spectral measurements and a plurality of corresponding stored response measurements, wherein the result of the database search comprises stored spectral measurements and corresponding stored response measurements, and
   in a database (340) comprising a plurality of stored predictive models, wherein the result of the database search comprises one or more stored predictive models; and

   determining (130) the predictive model based on at least the result of the database search.

2. Computer-implemented method (100) according to any one of the previous claims, wherein the predictive model is also determined (130) on the basis of the obtained spectral measurements of samples (320) of the target population.

3. Computer-implemented method (100) according to any one of the previous claims, wherein the step of obtaining (110) further comprises

   obtaining (111) one or more response measurements of the samples (320) of the target population,
   wherein each response measurement comprises one response value, and wherein the predictive model is also determined (130) on the basis of the obtained response values.

4. Computer-implemented method (100) according to any one of the previous claims, wherein the spectral and response measurements refer to one type of near-infrared spectroscopy, mid-infrared spectroscopy, Raman spectroscopy, Nuclear Magnetic Resonance spectroscopy or any other similar optical or emission-based spectroscopy, and wherein the model is provided for the same type of spectroscopy.

5. Computer-implemented method (100) according to any one of the previous claims, wherein the database search (120) is performed using an optimization method, preferably based on evolutionary search algorithms and/or sample similarity measurements.

6. Computer-implemented method (100) according to any one of the previous claims, wherein the step of determining (130) the predictive models is performed by means of machine learning and/or chemometrics methods.

7. Computer-implemented method (100) according to any one of the previous claims, further comprising packing (140) the predictive model into a spectroscopic application having a proprietary data format.

8. Method (200) for calibrating a spectroscopic device (310) configured for spectroscopy of a target population of a product or material, comprising:

   acquiring (210), by the spectroscopic device (310), one or more spectral measurements of samples (320) of the target population, wherein each spectral measurement comprises one or more sample spectral values;
   uploading (220) the acquired spectral measurements to a data processing server (350);
   generating (230), at the data processing server (350), a predictive model for spectroscopy according to one of claims 1 to 7;
   downloading (240) the predictive model from the data processing server (350); and
   installing (250) the downloaded predictive model into the spectroscopic device (310);
   wherein the predictive model predicts a response value indicating a physical and/or chemical property of the product or material from one or more spectral values indicating physical properties of the product or material,
   thereby calibrating the spectroscopic device (310) to be operational for the target population of the product or material.

9. Method (200) according to claim 8,

   wherein the step of acquiring (210) further comprises acquiring (211), by the spectroscopic device (310), one or more response measurements of the samples (320) of the target population, and

wherein the step of uploading (220) further comprises uploading (221) the acquired response measurements.

10. Method (200) according to any one of claims 8 to 9, wherein the spectroscopic device (320) is one of a near-infrared spectroscopy device, a mid-infrared spectroscopy device, a Raman spectroscopy device, a Nuclear Magnetic Resonance spectroscopy device or any other similar optical or emission-based spectroscopy device.

11. Method (200) according to any one of claims 8 to 10, further comprising, after installing (250):

acquiring (260), by the spectroscopy device (310), one or more additional spectral and/or response measurements of new target samples (320) of the target population; and
updating (270) the installed predictive model based on the measurements of the new target samples (320).

12. Computer program product including a program for a processing device, comprising software code portions for performing the steps of any one of claims 1 to 7 when the program is run on the processing device.

13. Computer program product according to claim 12, wherein the computer program product comprises a computer-readable medium on which the software code portions are stored, wherein the program is directly loadable into an internal memory of the processing device.

14. Device comprising processing means configured to perform the method according to any one of claims 1 to 7.

**Patentansprüche**

1. Computerimplementiertes Verfahren (100) zur Bereitstellung eines Vorhersagemodells für die Spektroskopie einer Zielpopulation eines Produkts oder Materials, wobei das Vorhersagemodell anhand eines oder mehrerer Spektralwerte, die physikalische Eigenschaften des Produkts oder Materials angeben, einen Antwortwert vorhersagt, der eine physikalische und/oder chemische Eigenschaft des Produkts oder Materials angibt, umfassend:

Erfassen (110) einer oder mehrerer Spektralmessungen von Proben (320) der Zielpopulation, wobei jede Spektralmessung einen oder mehrere Probenspektralwerte umfasst;
Durchführen (120) einer Datenbanksuche unter Verwendung der Probenspektralwerte als Eingabedaten, wobei als Ausgabedaten ein Datenbankergebnis vorliegt, das die Genauigkeit des Vorhersagemodells für die Spektroskopie anderer Proben (320) der Zielpopulation maximiert, wenn das Vorhersagemodell aus dem Ergebnis bestimmt wird;
wobei die Datenbanksuche durchgeführt wird

in einer Datenbank (330), die eine Vielzahl von gespeicherten Spektralmessungen und eine Vielzahl von entsprechenden gespeicherten Antwortmessungen umfasst, wobei das Ergebnis der Datenbankabfrage gespeicherte Spektralmessungen und entsprechende gespeicherte Antwortmessungen umfasst, und
in einer Datenbank (340), die eine Vielzahl von gespeicherten Vorhersagemodellen umfasst, wobei das Ergebnis der Datenbanksuche ein oder mehrere gespeicherte Vorhersagemodelle umfasst; und

Bestimmen (130) des Vorhersagemodells auf der Grundlage zumindest des Ergebnisses der Datenbanksuche.

2. Computerimplementiertes Verfahren (100) nach einem der vorhergehenden Ansprüche, wobei das Vorhersagemodell zudem auf der Grundlage der erhaltenen Spektralmessungen von Proben (320) der Zielpopulation bestimmt (130) wird.

3. Computerimplementiertes Verfahren (100) nach einem der vorhergehenden Ansprüche, wobei der Schritt des Erfassens (110) ferner umfasst

Erfassen (111) einer oder mehrerer Antwortmessungen der Proben (320) der Zielpopulation,
wobei jede Antwortmessung einen Antwortwert umfasst und wobei das Vorhersagemodell ebenfalls auf der Grundlage der erhaltenen Antwortwerte bestimmt (130) wird.

4. Computerimplementiertes Verfahren (100) nach einem der vorhergehenden Ansprüche, wobei sich die Spektral- und Antwortmessungen auf einen Typ von Spektroskopie beziehen, wie Nahinfrarotspektroskopie, Mittelinfrarotspektroskopie, Raman-Spektroskopie, Kernspinresonanzspektroskopie oder jede andere ähnliche optische oder emissionsbasierte Spektroskopie, und wobei das Modell für selbigen Typ von Spektroskopie bereitgestellt wird.

5. Computerimplementiertes Verfahren (100) nach einem der vorhergehenden Ansprüche, wobei die Datenbankabfrage (120) unter Verwendung eines Optimierungsverfahrens durchgeführt wird, vorzugsweise auf der Grundlage evolutionärer Suchalgorithmen und/oder Messungen der Ähnlichkeit von Proben.

6. Computerimplementiertes Verfahren (100) nach einem der vorhergehenden Ansprüche, wobei der Schritt des Bestimmens (130) der Vorhersagemodelle mittels Verfahren des maschinellen Lernens und/oder der Chemometrie durchgeführt wird.

7. Computerimplementiertes Verfahren (100) gemäß einem der vorhergehenden Ansprüche, das ferner das Verpacken (140) des Vorhersagemodells in eine spektroskopische Anwendung mit einem proprietären Datenformat umfasst.

8. Verfahren (200) zum Kalibrieren einer spektroskopischen Vorrichtung (310), die für die Spektroskopie einer Zielpopulation eines Produkts oder Materials konfiguriert ist, umfassend:

    Aufnehmen (210) einer oder mehrerer Spektralmessungen von Proben (320) der Zielpopulation durch das spektroskopische Gerät (310), wobei jede Spektralmessung einen oder mehrere Probenspektralwerte umfasst;
    Hochladen (220) der erfassten Spektralmessungen auf einen Datenverarbeitungsserver (350);
    Erzeugen (230) eines Vorhersagemodells für die Spektroskopie gemäß einem der Ansprüche 1 bis 7 auf dem Datenverarbeitungsserver (350);
    Herunterladen (240) des Vorhersagemodells vom Datenverarbeitungsserver (350); und
    Installieren (250) des heruntergeladenen Vorhersagemodells in der spektroskopischen Vorrichtung (310);
    wobei das Vorhersagemodell anhand eines oder mehrerer Spektralwerte, die physikalische Eigenschaften des Produkts oder Materials angeben, einen Antwortwert vorhersagt, der eine physikalische und/oder chemische Eigenschaft des Produkts oder Materials angibt,
    wodurch die spektroskopische Vorrichtung (310) so kalibriert wird, dass sie für die Zielpopulation des Produkts oder Materials einsatzfähig ist.

9. Verfahren (200) nach Anspruch 8,

    wobei der Schritt des Aufnehmens (210) ferner das Aufnehmen (211) einer oder mehrerer Antwortmessungen der Proben (320) der Zielpopulation durch die spektroskopische Vorrichtung (310) umfasst, und
wobei der Schritt des Hochladens (220) ferner das Hochladen (221) der erfassten Antwortmesswerte umfasst.

10. Verfahren (200) nach einem der Ansprüche 8 bis 9, wobei die spektroskopische Vorrichtung (320) eine Vorrichtung zur Nahinfrarotspektroskopie, eine Vorrichtung zur Mittelinfrarotspektroskopie, eine Vorrichtung zur Raman-Spektroskopie, eine Vorrichtung zur Kernspinresonanzspektroskopie oder eine andere ähnliche optische oder emissionsbasierte Spektroskopievorrichtung ist.

11. Verfahren (200) nach einem der Ansprüche 8 bis 10, das nach der Installation (250) ferner umfasst:

    Aufnehmen (260) einer oder mehrerer zusätzlicher Spektral- und/oder Antwortmessungen neuer Zielproben (320) der Zielpopulation durch die Spektroskopievorrichtung (310); und
    Aktualisieren (270) des installierten Vorhersagemodells auf der Grundlage der Messungen der neuen Zielproben (320).

12. Computerprogrammprodukt, das ein Programm für eine Verarbeitungsvorrichtung enthält, mit Softwarecodeabschnitten zur Ausführung der Schritte eines der Ansprüche 1 bis 7, wenn das Programm auf der Verarbeitungsvorrichtung ausgeführt wird.

13. Computerprogrammprodukt nach Anspruch 12, wobei das Computerprogrammprodukt ein computerlesbares Medium umfasst, auf dem die Software-Codeabschnitte gespeichert sind, wobei das Programm direkt in einen internen Speicher der Verarbeitungsvorrichtung geladen werden kann.

14. Vorrichtung, die Verarbeitungsmittel umfasst, die so konfiguriert sind, dass sie das Verfahren nach einem der Ansprüche 1 bis 7 ausführen.

**Revendications**

1. Procédé mis en œuvre par ordinateur (100) pour fournir un modèle prédictif pour spectroscopie d'une population cible d'un produit ou d'un matériau, dans lequel le modèle prédictif prédit une valeur de réponse indiquant une propriété physique et/ou chimique du produit ou du matériau à partir d'une ou plusieurs valeurs spectrales indiquant des propriétés physiques du produit ou du matériau, comprenant les étapes consistant à :

    obtenir (110) une ou plusieurs mesures spectrales d'échantillons (320) de la population cible, dans lequel chaque mesure spectrale comprend une ou plusieurs valeurs spectrales d'échantillon ;

effectuer (120) une recherche dans une base de données en utilisant les valeurs spectrales d'échantillon comme données d'entrée et en présentant comme données de sortie un résultat de base de données qui maximise la précision du modèle prédictif pour spectroscopie d'autres échantillons (320) de la population cible, lorsque le modèle prédictif est déterminé à partir du résultat ;

dans lequel la recherche dans une base de données est effectuée dans une base de données (330) comprenant une pluralité de mesures spectrales stockées et une pluralité de mesures de réponse stockées correspondantes, dans lequel le résultat de la recherche dans une base de données comprend des mesures spectrales stockées et des mesures de réponse stockées correspondantes, et

dans une base de données (340) comprenant une pluralité de modèles prédictifs stockés, dans lequel le résultat de la recherche dans une base de données comprend un ou plusieurs modèles prédictifs stockés ; et

déterminer (130) le modèle prédictif sur la base au moins du résultat de la recherche dans un base de données.

2. Procédé mis en œuvre par ordinateur (100) selon l'une quelconque des revendications précédentes, dans lequel le modèle prédictif est également déterminé (130) sur la base des mesures spectrales obtenues d'échantillons (320) de la population cible.

3. Procédé mis en œuvre par ordinateur (100) selon l'une quelconque des revendications précédentes, dans lequel l'étape d'obtention (110) comprend en outre l'étape consistant à

obtenir (111) une ou plusieurs mesures de réponse des échantillons (320) de la population cible, dans lequel chaque mesure de réponse comprend une valeur de réponse, et

dans lequel le modèle prédictif est également déterminé (130) sur la base des valeurs de réponse obtenues.

4. Procédé mis en œuvre par ordinateur (100) selon l'une quelconque des revendications précédentes, dans lequel les mesures spectrales et de réponse se réfèrent à un type de spectroscopie dans le proche infrarouge, de spectroscopie dans l'infrarouge moyen, de spectroscopie Raman, de spectroscopie par résonance magnétique nucléaire ou de toute autre spectroscopie optique ou à base d'émission similaire, et dans lequel le modèle est fourni pour le même type de spectroscopie.

5. Procédé mis en œuvre par ordinateur (100) selon l'une quelconque des revendications précédentes, dans lequel la recherche dans une base de données (120) est effectuée en utilisant un procédé d'optimisation, de préférence basé sur des algorithmes de recherche évolutifs et/ou des mesures de similitude d'échantillon.

6. Procédé mis en œuvre par ordinateur (100) selon l'une quelconque des revendications précédentes, dans lequel l'étape de détermination (130) des modèles prédictifs est effectuée au moyen de procédés d'apprentissage automatique et/ou de chimiométrie.

7. Procédé mis en œuvre par ordinateur (100) selon l'une quelconque des revendications précédentes, comprenant en outre l'intégration (140) du modèle prédictif dans une application spectroscopique présentant un format de données propriétaire.

8. Procédé (200) d'étalonnage d'un dispositif spectroscopique (310) configuré pour une spectroscopie d'une population cible d'un produit ou d'un matériau, comprenant les étapes consistant à :

acquérir (210), par l'intermédiaire du dispositif spectroscopique (310), une ou plusieurs mesures spectrales d'échantillons (320) de la population cible, dans lequel chaque mesure spectrale comprend une ou plusieurs valeurs spectrales d'échantillon ;

télécharger (220) les mesures spectrales acquises vers un serveur de traitement de données (350) ;

générer (230), au niveau du serveur de traitement de données (350), un modèle prédictif de spectroscopie selon l'une des revendications 1 à 7 ;

télécharger (240) le modèle prédictif à partir du serveur de traitement de données (350) ; et

installer (250) le modèle prédictif téléchargé dans le dispositif spectroscopique (310) ;

dans lequel le modèle prédictif prédit une valeur de réponse indiquant une propriété physique et/ou chimique du produit ou du matériau à partir d'une ou plusieurs valeurs spectrales indiquant des propriétés physiques du produit ou du matériau,

ce qui permet d'étalonner le dispositif spectroscopique (310) pour qu'il soit opérationnel pour la population cible du produit ou du matériau.

9. Procédé (200) selon la revendication 8,

dans lequel l'étape d'acquisition (210) comprend en outre une acquisition (211), par l'intermédiaire du dispositif spectroscopique (310), d'une ou plusieurs mesures de réponse des échantillons (320) de la population cible, et dans lequel l'étape de téléchargement (220) comprend en outre le téléchargement (221) des mesures de réponse acquises.

10. Procédé (200) selon l'une quelconque des revendications 8 à 9, dans lequel le dispositif spectroscopique (320) est un dispositif parmi un dispositif de spectroscopie dans le proche infrarouge, un dispositif de spectroscopie dans l'infrarouge moyen, un dispositif de spectroscopie Raman, un dispositif de spectroscopie à résonance magnétique nucléaire ou tout autre dispositif de spectroscopie optique ou à base d'émission similaire.

11. Procédé (200) selon l'une quelconque des revendications 8 à 10, comprenant en outre, après installation (250), les étapes consistant à :

acquérir (260), par l'intermédiaire du dispositif de spectroscopie (310), une ou plusieurs mesures spectrales et/ou de réponse supplémentaires de nouveaux échantillons cibles (320) de la population cible ; et
mettre à jour (270) le modèle prédictif installé sur la base des mesures des nouveaux échantillons cibles (320).

12. Produit de programme informatique incluant un programme pour un dispositif de traitement, comprenant des parties de code logiciel pour exécuter les étapes de l'une quelconque des revendications 1 à 7 lorsque le programme est exécuté sur le dispositif de traitement.

13. Produit de programme informatique selon la revendication 12, dans lequel le produit de programme informatique comprend un support lisible par ordinateur sur lequel les parties de code logiciel sont stockées, dans lequel le programme peut être chargé directement dans une mémoire interne du dispositif de traitement.

14. Dispositif comprenant des moyens de traitement configurés pour effectuer le procédé selon l'une quelconque des revendications 1 à 7.

# Fig.1

# Fig.2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102016124867 A1
- US 20200043574 A1
- US 20010037182 A1
- CN 108169132 A
- WO 2006126950 A1

- US 2022128474 A1
- US 2013080070 A1
- CN 106979934 A
- CN 109283153 A

**Non-patent literature cited in the description**

- **ADITYA TULSYAN**. A machine-learning approach to calibrate generic Raman models for real-time monitoring of cell culture processes. *Biotechnology and bioengineering*, 2019, vol. 116 (10), 2575-2586